# EUROPEAN PATENT APPLICATION

(11) **EP 1 414 064 A1**
(43) Date of publication of application: **28.04.2004**
(21) Application number: 03256414.8
(22) Date of filing: 10.10.2003
(51) Int. Cl.: H01L 23/373, H01L 21/48

(54) **Semiconductor device and package for housing semiconductor chip made of a metal-diamond composite**

(30) Priority: 22.10.2002 JP 2002306474
(71) Applicant: SUMITOMO ELECTRIC INDUSTRIES, LTD., Osaka-shi, Osaka (JP)
(72) Inventor: Saito, Hirohisa, c/o Itami Works, Itami-shi Hyogo (JP); Tsuno, Takashi, c/o Itami Works, Itami-shi Hyogo (JP); Kawai, Chihiro, c/o Itami Works, Itami-shi Hyogo (JP); Tanaka, Motoyoshi, c/o Itami Works, Itami-shi Hyogo (JP)
(74) Representative: Cross, Rupert Edward Blount

(57) **Abstract**

The present invention provides a semiconductor package allowing a semiconductor chip to be operated accurately and with high stability over a long period by effectively transferring the heat generated during the operation of the semiconductor chip to a heat sink. A package for housing a semiconductor chip comprises a substrate 2 having on the upper surface thereof a mounting space where a semiconductor chip 1 is to be mounted, a frame 3 being provided so as to surround the mounting space on the upper surface of the substrate 2 and having a joint 3a for an input/output terminal 5 on the side, and an input/output terminal 5 connected to the joint 3a, wherein the substrate 2, or part of the substrate 2, or the substrate 2 and the frame 3, or part of the substrate and the frame is formed from a metal-diamond composite in which a matrix material having diamond particles joined via a metal carbide is infiltrated with a copper and/or silver or a metal-diamond sintered body composed of diamond particles and copper. Further, the surface of the metal-diamond composite is plated with gold.

## Description

The present invention relates to a package for housing a semiconductor chip, such a package being suitable for housing a semiconductor chip of a variety of types, for example, a semiconductor integrated circuit chip such as an IC, an LSI, a field effect transistor (FET), a semiconductor laser (LD) and a photodiode (PD), and to a semiconductor device using such a package for housing a semiconductor chip.

A conventional package for housing a semiconductor chip (referred to hereinbelow as a semiconductor package) will be explained by the example of an optical semiconductor package which represents one type of semiconductor packages.

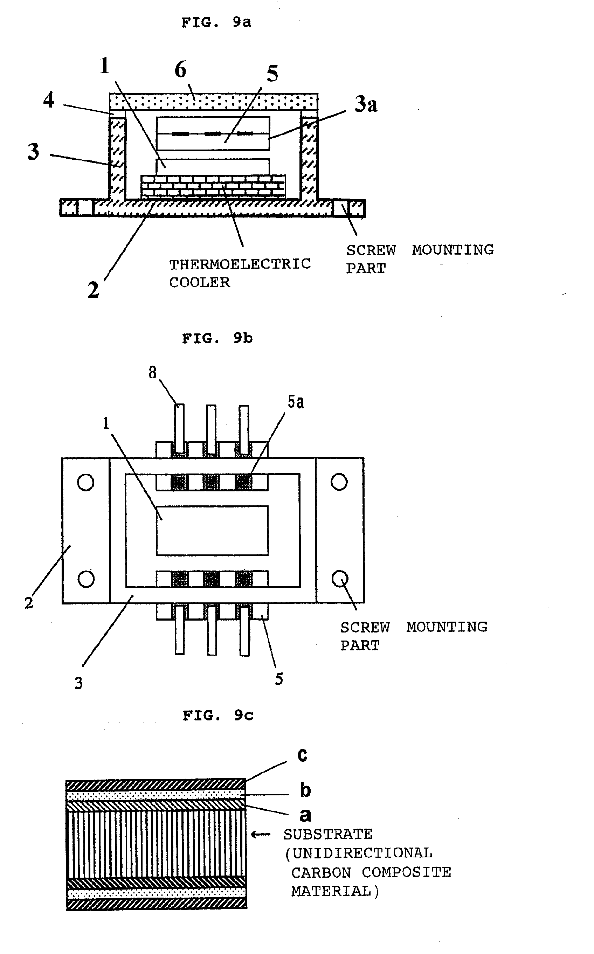

A conventional optical semiconductor package has a structure in which, as shown in FIG. 8, a thermoelectric cooler is placed on a substrate 2 and is located inside a Fe-Ni-Co alloy case in the form of a rectangular parallelepiped composed of the substrate 2, a frame 3, and a lid 6, and an optical semiconductor chip 1 is placed on top of the thermoelectric cooler. Following recent increase in output power of optical semiconductor chips, the introduced electric power is increased and the amount of generated heat also tends to increase. Accordingly, the drawback of the above-described configuration was that heat generated by the thermoelectric cooler itself acted upon the optical semiconductor chip 1, for example via the substrate 2 and the frame 3, and the efficiency of cooling the optical semiconductor chip 1 with the thermoelectric cooler decreased.

A variety of measures have been taken to dissipate the heat generated by the thermoelectric cooler in order to overcome the above-described drawback. Specific examples of such measures are described hereinbelow.

(a) Improvement of heat dissipation ability of the substrate (Japanese Patent Publication No. 2000-150746)
An optical semiconductor package, as shown in FIG. 9a, comprises an almost rectangular substrate 2 having on the upper surface thereof a mounting space with an optical semiconductor chip 1 mounted thereon via a thermoelectric cooler such as a Peltier chip and also having screw mounting part that is through holes or notches in the opposing side thereof, a frame 3 joined with a solder material such as a silver-copper solder to the upper surface of the substrate, so as to surround the mounting space, and having provided in the side thereof joint 3a that is a through hole or a notch for input/output terminals, input/output terminals 5 fit into the joint 3a, and a lid 6.

In the input/output terminals 5, as shown in FIG. 9b, metalized layers 5a are formed so as to pass through the frame 3, and lead terminals 8 joined to an external electric circuit are connected to the metalized layers 5a at the outside of the frame via a solder material such as a silver-copper solder. Furthermore, a seal ring 4 is joined to the upper surface of the frame 3 and the upper surface of the input/output terminals 5. The two upper surfaces lie in almost the same plane. The seal ring 4 functions as a bonding medium when the lid 6 is seam welded or solder joined to the frame 3.

In the substrate 2, as shown in FIG. 9c, metal layers having a three-layer structure comprising a first layer a composed of a chromium-iron alloy, a second layer b composed of copper, and a third layer c composed of an iron-nickel-cobalt alloy are coated on the upper and lower surfaces of a base material. This base material is composed of a unidirectional carbon composite material in which unidirectional carbon fibers arranged in a single direction from the upper surface side to the lower surface side of the base material are bonded with carbon.

The unidirectional carbon composite material has a very low modulus of elasticity in the transverse direction (direction perpendicular to the direction of the unidirectional carbon fibers) and a thermal expansion coefficient in this direction is about 7 ppm/°C. Coating the composite material with the above-mentioned metal layer produces a substrate in which a thermal expansion coefficient in the transverse direction is adjusted to 10-13 ppm/°C. Further, a thermal expansion coefficient of the substrate in the longitudinal direction (direction parallel to the direction of the unidirectional carbon fibers) approaches a thermal expansion coefficient of the unidirectional carbon fibers in the longitudinal direction (almost 0 ppm/°C) because a modulus of elasticity of the unidirectional carbon fibers in the longitudinal direction is very high.

There is a significant difference between thermal conductivity of the substrate 2 in the longitudinal direction and that in the transverse direction. The substrate has an extremely high thermal conductivity of no less than about 300 W/m·K in the longitudinal direction. Whereas, a thermal conductivity in the transverse direction is no more than about 30 W/m·K, which is extremely low, because a very large number of pores are present between individual unidirectional carbon fibers.

Such a substrate functions as the so-called heat dissipation sheet for effectively transferring the heat generated during the operation of the optical semiconductor chip to a heat sink because it is fastened with screws and tightly fixed to the heat sink of an external electric circuit via the screw mounting part.

After an optical semiconductor chip has been mounted on and fixed to the optical semiconductor package having such a substrate, the optical semiconductor chip and the metalized layer are electrically connected with a bonding wire, and the optical semiconductor chip is hermetically sealed with the lid to obtain an optical semiconductor device as a product. The optical semiconductor chip is actuated with a high-frequency signal input from an external electric circuit or with an optical signal input from an optical fiber.

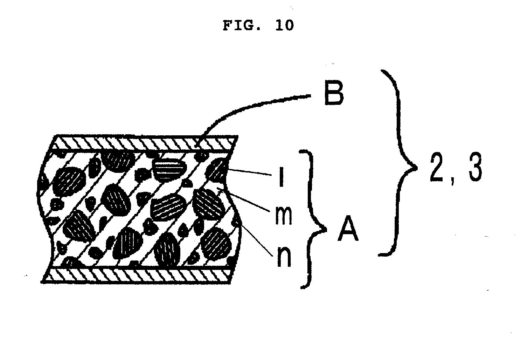

(b) Improvement of heat dissipation ability of the substrate and frame (Japanese Patent Publication No. 2002-252299)
A base material of the semiconductor package shown in FIG. 10 is a metal-carbon composite material A composed of unidirectional carbon fibers 1, a carbonaceous matrix material m, and copper and/or silver n and obtained by infiltrating the carbonaceous matrix material m having units of unidirectional carbon fibers 1 dispersed therein with copper and/or silver n. A material obtained by coating the surface of the base material with a copper plated layer B serves as the material of the substrate and frame. In this semiconductor package, heat is effectively dissipated even without a thermoelectric cooler, because heat is transferred in all the directions, by contrast with the base material described in section (a) hereinabove that had thermal conduction only in the longitudinal direction.

However, the problem was that the amount of heat generated during the operation of optical semiconductor chips has been further increasing following the increase in the output thereof in recent years, and this heat could not be effectively dissipated, causing heat accumulation in the hollow space (inner space) formed by the substrate and the frame, which resulted in degraded operation performance of the optical semiconductor chip or thermal fracture.

Mounting additionally a thermoelectric cooler or further increasing the size to improve the efficiency of thermal conduction was also considered as means for resolving this problem. However, in this case the size of optical semiconductor package became larger, which was contrary to the recent trend toward decrease in size and weight of optical semiconductor packages.

Furthermore, if the screw mounting parts are fastened tightly with screws at a high torque to the heat sink, in order to fix tightly and strongly the optical semiconductor package to the external electric circuit and to increase the efficiency of heat transfer to the heat sink, tight fixing of the optical semiconductor package to the heat sink becomes impossible, because, the screw mounting parts, which have a compressive strength much smaller than that of metals, are crushed in the thickness direction. The resulting problem is that the heat generated by the optical semiconductor chip is not transferred to the heat sink, which results in degraded operation performance of the optical semiconductor chip or thermal fracture.

Those problems are not limited to the above-described optical semiconductor packages and are also associated with semiconductor packages for housing semiconductor integrated circuit chips such as IC, LSI, or one of a variety of semiconductor chips such as FET, wherein the substrates function as heat dissipation sheets.

The present invention was completed with the aforesaid problems in view, and it is an object of the present invention to provide a semiconductor package allowing a semiconductor chip, for example, a semiconductor integrated circuit chip such as IC, LSI, or one of a variety of semiconductor chips such as FET, LD, PD, to be operated accurately and with high stability over a long period by effectively transferring the heat generated during the operation of the semiconductor chip to a heat sink, and also to provide a semiconductor device using such a semiconductor package.

Based on the results of a comprehensive study, the inventors have discovered that the above-described problems can be resolved by improvements of the material forming the substrate and the frame and have achieved the present invention. The constitution of the present invention is described below.

(1) A package for housing a semiconductor chip comprising a substrate having on an upper surface thereof a mounting space where a semiconductor chip is to be mounted, a frame being provided so as to surround said mounting space on the upper surface of said substrate and having a joint for an input/output terminal on a side thereof, and an input/output terminal connected by fitting or joining to said joint, wherein said substrate, or part of said substrate, or said substrate and said frame, or part of said substrate and said frame is formed from a metal-diamond composite in which a matrix material having diamond particles joined via a metal carbide is infiltrated with a metal containing copper and/or silver as a main component.

(2) A package for housing a semiconductor chip, according to clause (1) hereinabove, wherein at least part of a surface of said metal-diamond composite is plated with gold.

(3) A package for housing a semiconductor chip comprising a substrate having on an upper surface thereof a mounting space where a semiconductor chip is to be mounted, a frame being provided so as to surround said mounting space on the upper surface of said substrate and having a joint for an input/output terminal on a side thereof, and an input/output terminal connected by fitting or joining to said joint, wherein said substrate, or part of said substrate, or said substrate and said frame, or part of said substrate and said frame is formed from a metal-diamond sintered body having no pores inside thereof, diamond particles with a particle size of no less than 5 µm and no more than 100 µm as a main component, a balance being substantially copper, and a thermal conductivity of no less than 500 W/m·K and no more than 1500 W/m·K.

(4) A package for housing a semiconductor chip, according to clause (3) hereinabove, wherein at least part of a surface of said metal-diamond sintered body is plated with gold.

(5) A package for housing a semiconductor chip, according to any of clauses (1)-(4) hereinabove, wherein a screw mounting part that is a through hole or a notch is formed in each opposing side of said substrate.

(6) A semiconductor device comprising a package for housing a semiconductor chip according to any of clauses (1)-(5) hereinabove, a semiconductor chip mounted on and fixed to said mounting space, and a lid joined to an upper surface of said frame.

FIG. 1 illustrates an example of a semiconductor device using the package for housing a semiconductor chip in accordance with the present invention;

FIG. 2 is a partially expanded cross-sectional view of the substrate and frame of the semiconductor package in accordance with the present invention;

FIG. 3 illustrates an example of a semiconductor device using the package for housing a semiconductor chip in accordance with the present invention;

FIG. 4 illustrates an example of the package for housing a semiconductor chip in accordance with the present invention;

FIG. 5 illustrates an example of a method for the manufacture of the metal-diamond composite in accordance with the present invention;

FIG. 6 illustrates an example of a semiconductor device using the package for housing a semiconductor chip in accordance with the present invention;

FIGS. 7a and 7b illustrate an example of a semiconductor device using the package for housing a semiconductor chip in accordance with the present invention;

FIG. 8 illustrates an example of a semiconductor device using a conventional package for housing a semiconductor chip;

FIGS. 9a, 9b and 9c illustrate another example of a semiconductor device using a conventional package for housing a semiconductor chip; and

FIG. 10 is a partially expanded cross-sectional view of a substrate and frame of a conventional semiconductor package.

The semiconductor package in accordance with the present invention will be described below in greater detail with reference to the appended drawings.

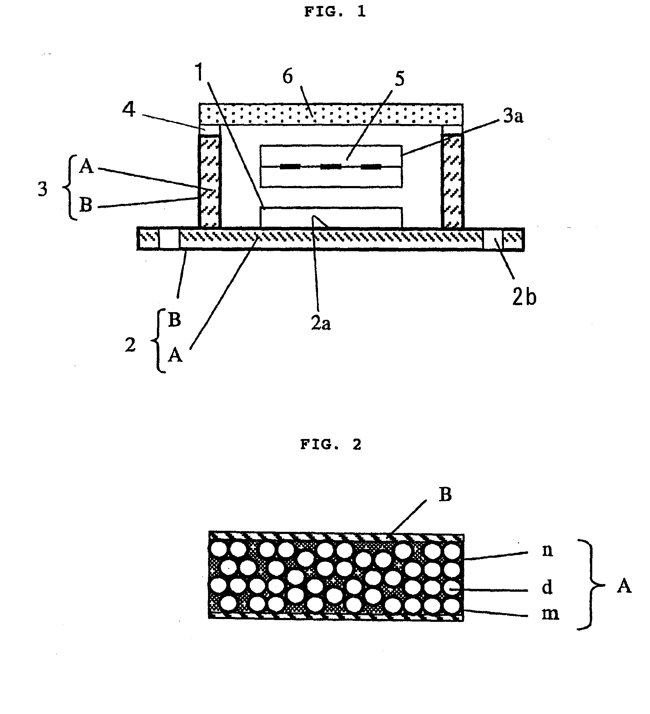

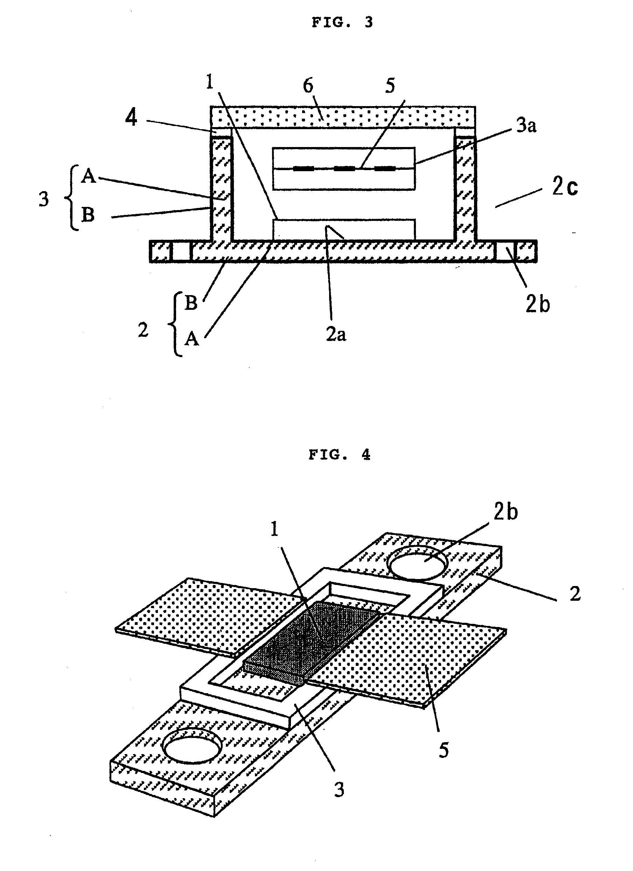

FIGS. 1 to 7 illustrate an example of the preferred embodiment of the semiconductor package in accordance with the present invention. FIG. 1 is a cross-sectional view illustrating an example of the semiconductor package. FIG. 2 is a partial enlarged cross-sectional view of a substrate and a frame of the semiconductor package. FIG. 3 is a cross-sectional view of the semiconductor package in which the substrate and the frame were formed integrally. FIG. 4 is a perspective view illustrating another example of the semiconductor package.

The preferred embodiment of the present invention illustrated by FIG. 1 will be described hereinbelow.
FIG. 1 illustrates an example in which a metal-diamond composite was used as a material for the substrate and the frame. Referring to FIG. 1, the reference numeral 1 stands for a semiconductor chip, 2 shows a substrate obtained by forming a gold plated layer B on the surface of the base material composed of the metal-diamond composite A, 3 is a frame of approximately a rectangular shape in the plan view thereof and the frame is obtained by forming a gold plated layer B on the surface of a base material composed of a metal-diamond composite A, 4 stands for a sealing material joined onto the upper surface of the frame 3, and 5 is an input/output terminal fitted into a joint 3a of the frame 3. A container housing the semiconductor chip 1 is mainly composed of these substrate 2, frame 3, sealing material 4, and input/output terminal 5.

FIG. 2 shows a partially expanded cross-sectional view of the substrate 2 and the frame 3. The substrate and the frame are composed of a metal-diamond composite A, which comprises diamond particles d, a metal carbide m, and a metal n containing copper and/or silver as the main component and is coated with a gold plated layer B on the surface thereof.

A thermal expansion coefficient of the metal-diamond composite A in accordance with the present invention is controlled to 5-10 ppm/°C by infiltrating the base with the metal n containing copper and/or silver as the main component. Further, infiltrating with the metal n containing copper and/or silver as the main component increases the rigidity of the metal-diamond composite A. Thereby, the metal-diamond composite A can be fixed strongly without being broken when the semiconductor package is fixed by fastening with screws to an external electric circuit via screw mounting parts.

Copper and/or silver is used as the metal for infiltrating the metal-diamond composite A because those metals have a thermal expansion coefficient of 17-20 ppm/°C, a thermal conductivity of no less than 390 W/m·K, a modulus of elasticity of no less than 80 GPa, and a melting point of no less than 900°C, those characteristics being advantageous from the standpoint of fabrication and characteristics of semiconductor packages.

More specifically, as for the thermal expansion coefficient, if a matrix material in which the diamond particle d are joined via the metal carbide m is infiltrated with an appropriate amount of the metal n containing copper and/or silver as the main component, then the thermal expansion coefficient of the metal-diamond composite A will not be increased to a level substantially different from that of the semiconductor chip 1. Furthermore, because copper and silver have a very high thermal conductivity, they are advantageous for transferring the heat generated during the operation of the semiconductor chip 1.

As for the modulus of elasticity, because the metal n containing copper and/or silver as the main component functions as a buffer material when the screws are tightened, the substrate 2 can be prevented from fracture more efficiently than in the conventional materials. Because the metal n containing copper and/or silver as the main component has a very high melting point, no melting thereof occurs even when the semiconductor package is assembled with a solder such as a silver-copper solder with a melting point of no less than about 780°C. And also, it is possible to keep steadily the inside state of the matrix in which the diamond particles d are joined with the metal carbide m stabilized. On the other hand, if a metal which melts at the aforesaid temperature is used, this metal can ooze out from the end surface of the substrate 2 or the frame 3. Such a metal is inappropriate as a material for semiconductor packages.

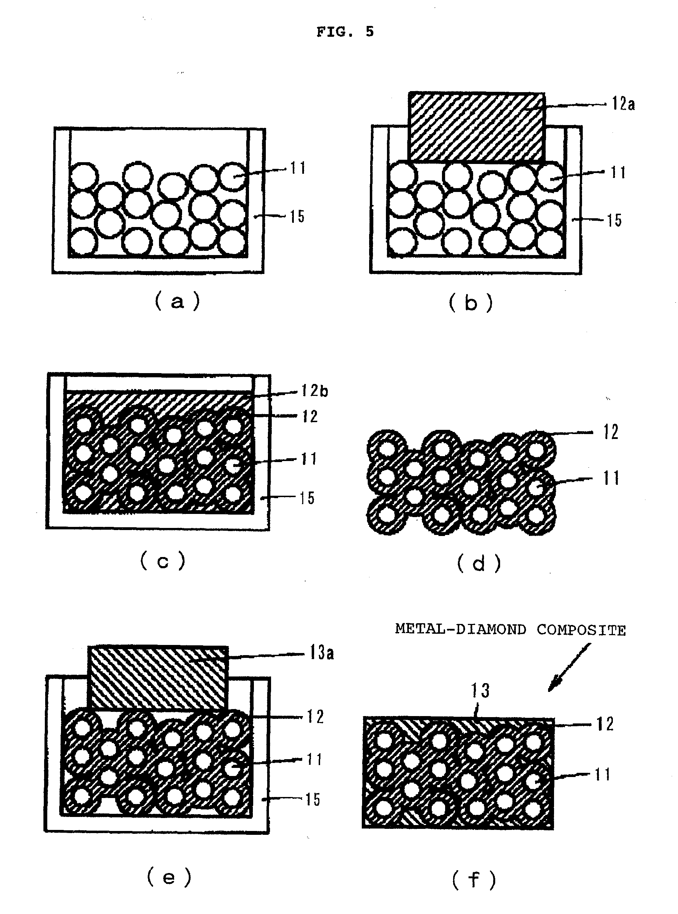

An example of the method for manufacturing the metal-diamond composite A will be explained below based on FIGS. 5(a)-(f), but the method for the manufacture of the metal-diamond composite in accordance with the present invention is not limited to the below-described manufacturing example.

First, as shown in FIG. 5(a), diamond particles 11 are packed inside a container 15. Then, as shown in FIG. 5(b), a metal ingot 12a is arranged so as to be in contact with the diamond particles 11. The metal ingot 12a is made of an alloy of, for example, Ti (a metal component constituting the metal carbide) and at least one of Ag, Cu, Al and Au. In addition to Ti, the preferred metal components constituting the metal carbide include Zr and Hf, moreover, a combination of metals selected from Group 4a-7a metals may be also used. From the standpoint of thermal characteristics, a small amount of Ti is preferred, but if it is too small, no effect is produced. For this reason, it is preferred that the metal ingot 12a contains about 0.1-8.0 wt% Ti.

As shown in FIG. 5(c), if the metal ingot 12a is heated and melted and the molten metal 12b is caused to permeate between the diamond particles 11, then Ti contained in the molten metal 12b will react with the diamond, forming a metal carbide 12 composed of TiC on the surface of diamond particles 11.

Graphite is sometimes simultaneously formed under such conditions, the graphite being transformed from diamond. The higher is the melting temperature of the metal ingot 12a and the longer is the time of heating conducted for melting, the easier is the formation of the graphite. An alloy can be effectively used as the molten metal ingot 12a because the melting point of the ingot will be lowered, it will be easier to melt, and damage of the diamond will be prevented or the amount of the graphite formed will be decreased. Thermal conductivity of graphite is not as good as that of diamond therefore a small amount of graphite is preferred. On the other hand, sometimes graphite effectively links together the diamond particles. If present in small amounts, it produces no significant damage on thermal conductivity and creates no problem.

After the metal 12b is heated in vacuum and evaporated, only the diamond 11 and the metal carbide 12 remain, as shown in FIG. 5(d). In this case, a structure in which the diamond 11 is present in the matrix of the metal carbide 12 is obtained. The diamond 11 forms particles and these diamond particles 11 are joined together with the metal carbide 12 in this structure. Pores are also present in such a matrix composed of the diamond particles 11 and the metal carbide 12.

Then, as shown in FIG. 5(e), a metal ingot 13a of copper and/or silver is arranged so as to be in contact with the matrix composed of the diamond particles 11 and the metal carbide 12. The metal-diamond composite A shown in FIG. 5(f) can be obtained by melting the metal ingot 13a, causing the melt to permeate into the pores in the matrix composed of the diamond particles 11 and the metal carbide 12, filling the pores, and removing the product from the container 15 once the permeated metal 13 has solidified.

It is preferred that a gold plated layer B be formed on the surface of the metal-diamond composite A, as shown in FIG. 2. The gold plated layer B has a function of completely covering the surface of the metal n containing copper and/or silver as the main component, which is exposed on the surface of the metal-diamond composite A, and suppressing oxidation and corrosion in the environment where the composite is used. Moreover, the gold plated layer also functions as the so-called heat-transfer medium, which transfers the heat generated during the operation of the semiconductor chip 1 in the transverse direction. The gold plated layer B also serves as the so called soldering-improving medium, which increases solderability when members to be joined to the substrate 2 or frame 3 are joined with a solder such as a gold (Au) - tin (Sn) or silver (Ag) - copper (Cu) solder.

The package satisfies the standard when air tightness of the inside of the semiconductor package is inspected using helium (He), because the gold plated layer B effectively prevents a portion of helium (He) from being trapped in the pores of the metal-diamond composite. In addition, because the heat generated during the operation of the semiconductor chip 1 is transferred from the joint (mounting space 2a) where the semiconductor chip 1 is joined (mounted) along the gold plated layer B, this heat can be dissipated with good efficiency from the entire inner region of the semiconductor package through the entire outer surface of the semiconductor package, and then through a heat sink into the atmosphere.

The thickness of the gold plated layer B is preferably 0.2-5 µm. If it is less than 0.2 µm, the effect of suppressing the oxidation of copper and/or silver exposed on the surface of the metal-diamond composite is lost because of pinholes or the like. Furthermore, when the semiconductor chip 1 and input/output terminals 5 are joined by a solder such as a Au-Sn or Ag-Cu solder, solderability of the material is prone to be lost, the gold plated layer losses its function as a heat-transfer medium, and the air tightness exhibits unstableness for the air tightness inspection of the inside of the semiconductor package. On the other hand, when the thickness is above 5 µm, strains caused by thermal stresses occurring between the metal-diamond composite A and the gold plated layer B increase and the gold plated layer B is inclined to be peeled off. It is also undesirable from the standpoint of cost efficiency.

In the configuration shown in FIG. 1, the frame 3 joined to the upper surface of the substrate 2 with a solder, for example a silver-copper solder with a very high thermal conductivity, is composed of the same material as the substrate 2. Therefore, even when the heat generated by the semiconductor chip 1 is transferred from the substrate 2 to the frame 3, it can be effectively dissipated from the frame 3 to the outside (into the atmosphere). Thus, even when a very large amount of heat is generated during the operation of the semiconductor chip 1, the heat can be effectively dissipated through the two paths: a path leading from the substrate 2 to the atmosphere via the frame 3 and a path leading from the substrate 2 to a heat sink. The frame may be composed of another insulating material, an example thereof being described below.

The four side walls of the frame 3 of approximately a rectangular shape in the plan view thereof, which surround the semiconductor chip 1, may be formed as independent pieces. The heat generated during the operation of the semiconductor chip 1 may be effectively dissipated in the same manner as described hereinabove, even when each of the pieces is joined via a solder, for example a silver-copper solder. The number of pieces is not limited to four and the following configurations may be also used: a configuration in which two pieces each having two side walls connected to each other are joined with a solder material such as a silver-copper solder; a configuration in which one piece is joined to an opening in a U-shaped structure obtained by connecting three side walls; and a configuration in which one side wall is divided in no less than two sections which are joined with a solder material.

The substrate 2 and the frame 3 have a thermal conductivity of about 400-800 W/m·K. As a result, even when the amount of heat generated during the operation of the semiconductor chip is very large, the heat can be dissipated with good efficiency via the two paths: a path by which the heat is transferred at random with good efficiency from the substrate 2 to the frame 3 and eventually to the atmosphere and a path by which the heat is transferred at random from the substrate 2 to a heat sink.

Accordingly, the semiconductor package can be fixed strongly and tightly with screws to an external electric circuit via the screw mounting parts 2b of the substrate 2. Moreover, the heat generated during the operation of the semiconductor chip 1 can be transferred effectively from the substrate 2 to the heat sink and also heat can be transferred from the substrate 2 to the frame 3 and dissipated eventually in the atmosphere.

Joints 3a of the input/output terminals 5 are provided on the side of the frame 3, and the input/output terminals 5 are fit with a solder material such as a Ag-Cu solder via the gold plated layer B on the inner peripheral surface of the joints 3a. As for the input/output terminals 5, an electrically insulating ceramic substrate is coated with an electrically conductive metalized layer 5a, and the terminal has a function of maintaining the air tightness of the inside of the semiconductor package and a function of conducting input and output of high-frequency signals to and from the semiconductor package and an external electric circuit. A ceramic material such as an alumina (Al₂O₃) ceramic or an aluminum nitride (AlN) ceramic is appropriately selected as the ceramic base material according to characteristics thereof such as dielectric constant and thermal expansion coefficient.

The input/output terminal is manufactured as follows: an organic or another solvent is added to a powder, for example of tungsten (W), molybdenum (Mo), or manganese (Mn) that will form a metalized layer 5a; they are mixed to obtain a metallic paste; meanwhile, a ceramic green sheet is prepared by adding an appropriate organic binder or solvent to a powdered starting material for a ceramic substrate and then molding these materials by a doctor blade method or a calender roll method; the ceramic green sheet is coated with the metallic paste according to the desired shape by printing using a conventional screen printing method; and then the sheet is sintered at a high temperature of about 1600°C.

Furthermore, a lid 6 is seam welded to the upper surface of the frame 3, or a seal ring 4 composed of a metal, for example a Fe-Ni-Co alloy or a Fe-Ni alloy functioning as medium for Au-Sn bonding, is joined with a solder material such as a Ag-Cu solder to the upper surface of the frame. When the seal ring is formed, for example, from a Fe-Ni-Co alloy, the prescribed shape is manufactured by subjecting an ingot of this alloy to metal processing such as rolling or pressing. In order to prevent effectively the oxidation and corrosion, a metal layer such as a Ni layer with a thickness of 0.5-9 µm or a Au layer with a thickness of 0.2-5 µm may be coated on the ring surface by plating.

A metal composed of a Fe-Ni-Co alloy, a Fe-Ni alloy, or the like, or a ceramic composed of an Al₂O₃ ceramic, an AlN ceramic, or the like, is joined as a lid 6 to the upper surface of the seal ring 4 to seal hermetically the inside of the semiconductor package.

The explanation given hereinabove related to the case in which the metal-diamond composite was used as the material of the substrate and frame. However, a metal-diamond sintered body can be also used instead of the metal-diamond composite. For the metal-diamond sintered body, a sinter comprising diamond particles with a particle size of no less than 5 µm and no more than 100 µm, having no pores inside thereof, a thermal conductivity of no less than 500 W/m·K and no more than 1500 W/m·K, and the balance being substantially copper, is used.

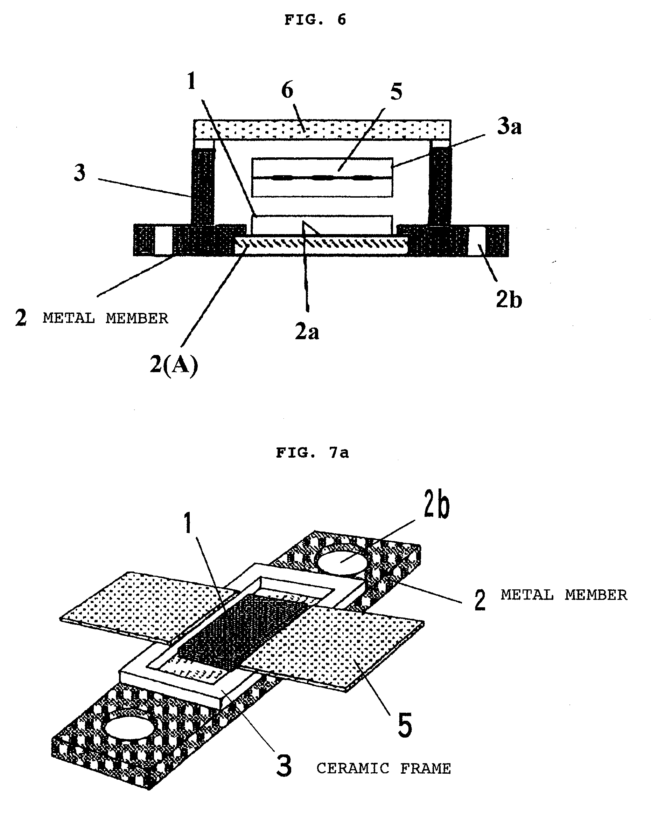

In the examples described hereinabove, the substrate and frame of the semiconductor package were fabricated from the metal-diamond composite or the metal-diamond sintered body. However, it is also possible to use the metal-diamond composite or the metal-diamond sintered body for only part of the substrate, for example, as shown in FIG. 6. Such a semiconductor package provides a sufficient heat sink capability in case that an output of the semiconductor chip is not too high, therefore, that is effective in terms of cost efficiency.

A semiconductor device as a product is produced by assembling the semiconductor package in accordance with the present invention, the semiconductor chip 1 mounted on and fixed to the mounting space 2a and electrically connected to the input/output terminals 5, and the lid 6 joined to the upper surface of the frame 3 and sealing the semiconductor chip 1.

More specifically, the semiconductor chip 1 is adhesively fixed to the upper surface of the mounting space 2a via an adhesive agent such as a glass, a resin or a solder material, and an electrode of the semiconductor chip 1 is electrically connected to the prescribed metalized layer 5a via a bonding wire. Thereafter, the lid 6 is joined to the upper surface of the sealing ring 4 with a glass, a resin, a solder material, or by seam welding, thereby the semiconductor chip 1 is air-tightly housed inside the semiconductor package composed of the substrate 2, frame 3, sealing ring 4, and input/output terminals 5. A semiconductor device as a product is completed by joining the lid 6 to the upper surface of the semiconductor package.

The present invention is not limited to the above-described preferred embodiment and various modifications may be made without departing from the purport of the present invention. For example, in the case that the semiconductor chip 1 is a photosensitive semiconductive chip such as a LD, a PD, or a LED, the semiconductor package should furnish an optical fiber fixing member for fixing an optical fiber to the side of the frame 3 and an optical fiber which is adhesively fixed to the optical fiber fixing member, in order to provide an optical semiconductor package. An optical semiconductor device as a product is completed by joining a lid for sealing the optical semiconductor chip to the upper surface of the optical semiconductor package.

The above-described optical semiconductor device can function as an optical semiconductor device capable of transmitting a large volume of information at a high speed and can be widely used in the field of optical communications or the like by sending and receiving a light, which is for example a laser light generated by optical excitation of the optical semiconductor chip with a high-frequency signal supplied from an external electric circuit, through an optical fiber with a transparent member adhesively fixed to the optical fiber fixing member and functioning as a condensing lens, and then communicating the light via inside the optical fiber.

A semiconductor package of another embodiment of the present invention will be described hereinbelow based on FIG. 3 and FIG. 4. In the configuration shown in FIG. 3, the container 2c in the semiconductor package shown in FIG. 1 is formed by integrally molding the substrate 2 and the frame 3. With such a configuration obtained without a solder material such as a Ag-Cu solder, between the substrate 2 and the frame 3, the heat generated during the operation of the semiconductor 1 can be also dissipated with good efficiency, similarly to the configuration shown in FIG. 1.

FIG. 4 is a perspective view of another example of the semiconductor package in accordance with the present invention. Referring to FIG. 4, the reference symbol 1 stands for a semiconductor chip, 2 is a substrate obtained by forming a gold plated layer B on the surface of a base material composed of the metal-diamond composite A, 5 indicates an input/output terminal for supplying signals to the semiconductor chip 1, 3 is a frame formed from an electrically insulating material such as an Al₂O₃ ceramic, an AlN ceramic, or a ceramic sintered at a low temperature (LTCC: Low Temperature Co-fired Ceramics), or obtained by forming an electrically insulating layer on the section, which is joined to the input/output terminals and locates the upper surface of a metal material such as the metal-diamond composite. A container housing the semiconductor chip 1 is mainly composed of these substrate 2, frame 3, sealing material 4, and input/output terminals 5.

The frame 3, as mentioned hereinabove, is most often fabricated from an Al₂O₃ ceramic, an AlN ceramic, or a ceramic sintered at a low temperature. In order to connect the input/output terminals 5, a layer of a metal based on copper (Cu) or a layer of a metal based on tungsten (W), molybdenum (Mo), manganese (Mn), or silver (Ag) that will form a metalized layer is fabricated by printing and coating according to the desired shape by a screen printing method and sintering at a high temperature. It is also possible to use a configuration in which the entire frame 3 is not from a ceramic. Thus, a through hole or a notch may be made in part of the metal-diamond composite A and an input/output terminal composed of a ceramic and a metal may be fit inside thereof via a solder material.

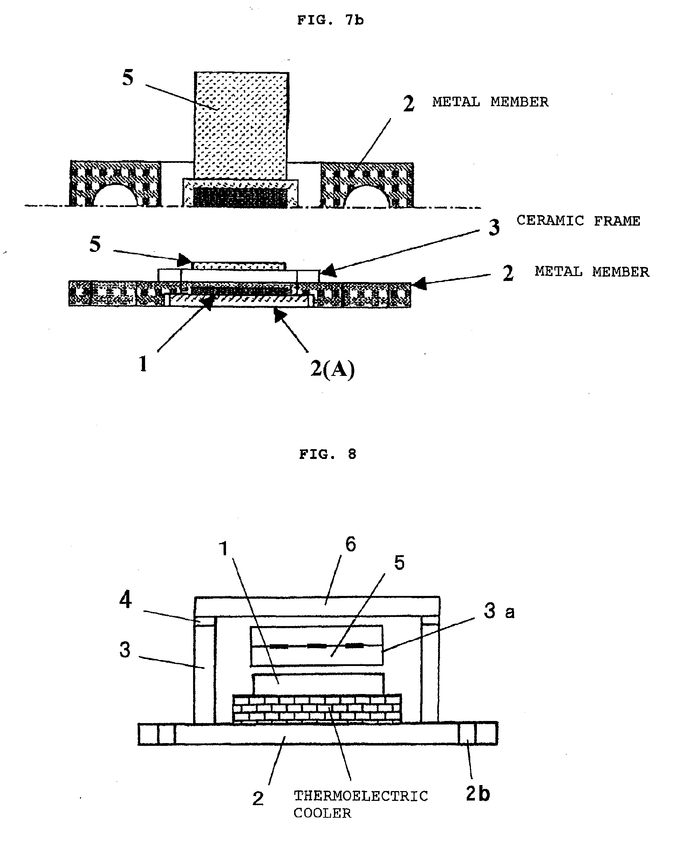

As shown in FIG. 7, the metal-diamond composite or the metal-diamond sintered body can be also used only for part of the semiconductor package substrate. Such a semiconductor package can serve a sufficient heat sink capability in case that an output of the semiconductor chip is not too high, therefore, that is effective in terms of cost efficiency.

As shown in FIG. 4, after the semiconductor chip has been mounted, a lid from a material having electric insulating properties such as a resin is attached to the upper portion of the semiconductor package (the lid is not shown in FIG. 4). A semiconductor device is obtained by providing a semiconductor chip 1 which is to be mounted on and fixed to the mounting space and electrically connected to the input/output terminal 5 in such a semiconductor package.

More specifically, the semiconductor chip 1 is adhesively fixed to the upper surface of the mounting space via an adhesive agent such as a glass, a resin or a solder material, and an electrode of the semiconductor chip 1 is electrically connected to the prescribed terminal joint via a bonding wire or a bonding ribbon. The resin lid is thereafter joined to the upper surface, thereby producing a semiconductor device as a product in which the semiconductor chip 1 is contained inside the semiconductor package composed of the substrate 2, frame 3, input/output terminals 5, and lid.

The present invention is not limited to the above-described preferred embodiments, and various modifications may be made without departing from the purport of the present invention. For example, when the semiconductor chip 1 contained inside the semiconductor package is a MMIC or the like for wireless communication, a semiconductor device product is obtained by furnishing a device for power amplification or a substrate in which an antenna is formed by thick-film metalization on an Al₂O₃ ceramic substrate .

In such a semiconductor device for wireless communication, a radio semiconductor chip is activated, for example, by a high-frequency signal supplied from an external electric circuit, the signal produced is amplified by a power amplifier, and a radio signal is transmitted through the antenna. As a result, the device functions as a radio signal generator and can be widely used in the field of wireless communication.

In the semiconductor package in accordance with the present invention, a particular material that is produced by preparing a matrix in which diamond particles are joined via a metal carbide, infiltrating the matrix with copper and/or silver to form the metal-diamond composite, and then providing a gold plated layer thereon, is used as a material of the substrate or the substrate and the frame. As a result, the semiconductor package can be strongly and tightly fixed with screws to an external electric circuit, and the heat generated during the operation of the semiconductor chip is effectively transferred via the substrate and the frame and dissipated via a heat sink of the external electric circuit or into the atmosphere. Furthermore, in the semiconductor package in accordance with the present invention, at least part of the surface of the substrate and/or the frame is coated with a gold plated layer, therefore, copper and/or silver exposed on the surface of the metal-diamond composite is prevented from oxidation and corrosion, and the semiconductor chip sealed inside the package can be used with high stability over a long period.

Furthermore, the present invention can also provide a highly reliable semiconductor device by using the above-described semiconductor package.

## Claims

1. A package for housing a semiconductor chip comprising a substrate having on an upper surface thereof a mounting space where a semiconductor chip is to be mounted, a frame being provided so as to surround said mounting space on the upper surface of said substrate and having a joint for an input/output terminal on a side thereof, and an input/output terminal connected by fitting or joining to said joint, wherein said substrate, or part of said substrate, or said substrate and said frame, or part of said substrate and said frame is formed from a metal-diamond composite in which a matrix material having diamond particles joined via a metal carbide is infiltrated with a metal containing copper and/or silver as a main component.

2. A package for housing a semiconductor chip according to claim 1, wherein at least part of a surface of said metal-diamond composite is plated with gold.

3. A package for housing a semiconductor chip comprising a substrate having on an upper surface thereof a mounting space where a semiconductor chip is to be mounted, a frame being provided so as to surround said mounting space on the upper surface of said substrate and having a joint for an input/output terminal on a side thereof, and an input/output terminal connected by fitting or joining to said joint, wherein said substrate, or part of said substrate, or said substrate and said frame, or part of said substrate and said frame is formed from a metal-diamond sintered body having no pores inside thereof, diamond particles with a particle size of no less than 5 µm and no more than 100 µm as a main component, a balance being substantially copper, and a thermal conductivity of no less than 500 W/m·K and no more than 1500 W/m·K.

4. A package for housing a semiconductor chip according to claim 3, wherein at least part of a surface of said metal-diamond sintered body is plated with gold.

5. A package for housing a semiconductor chip according to any of claims 1 to 4, wherein a screw mounting part that is a through hole or a notch is formed in each opposing side of said substrate.

6. A semiconductor device comprising a package for housing a semiconductor chip according to any of claims 1 to 5, a semiconductor chip mounted on and fixed to said mounting space, and a lid joined to an upper surface of said frame.
